# EUROPÄISCHE PATENTSCHRIFT

(11) **EP 2 111 092 B1**
(45) Veröffentlichungstag und Bekanntmachung des Hinweises auf die Patenterteilung: **27.05.2015**
(21) Anmeldenummer: 09154944.4
(22) Anmeldetag: 12.03.2009
(51) Int. Cl.: H05K 13/04

(54) **Bestückkopf, Bestückautomat, Verfahren zum Abholen von Bauelementen sowie Verfahren zum Bestücken von Substraten**
Loading head, automatic loader, method for fetching construction elements and method for loading substrates
Tête à implanter, automate d'implantation, procédé destiné à aller chercher des composants et procédé destiné à implanter des substrats

(30) Priorität: 16.04.2008 DE 102008019100
(43) Veröffentlichungstag der Anmeldung: 21.10.2009
(73) Patentinhaber: ASM Assembly Systems GmbH & Co. KG, 81379 München (DE)
(72) Erfinder: Mehdianpour, Mohammad, 81829, München (DE); Müller, Werner, 83607, Holzkirchen (DE)
(74) Vertreter: Kuhlmann, Kai

(56) Entgegenhaltungen:
- EP-A1- 0 401 808
- WO-A1-99/53741
- JP-A- 2001 135 993

## Beschreibung

Die Erfindung betrifft das Gebiet der automatischen Bestückung von Substraten mittels Bestückautomaten, welche einen Bestückkopf zum temporären Halten von Bauelementen aufweisen, so dass bei einer entsprechenden Bewegung des Bestückkopfes die Bauelemente aufgenommen, transportiert und auf einem Bauelementeträger aufgesetzt werden können. Die vorliegende Erfindung betrifft insbesondere einen Bestückkopf zum Bestücken von Substraten mit Bauelementen. Ferner betrifft die vorliegende Erfindung einen Bestückautomaten, ein Verfahren zum Abholen von Bauelementen sowie ein Verfahren zum Bestücken von Substraten.

In der Bestücktechnik werden Substrate, beispielsweise Leiterplatten, mit Hilfe sogenannter Bestückautomaten mit Bauelementen verschiedenster Art bestückt. Hierzu werden die Bauelemente durch am Bestückautomaten angeordnete Zuführeinrichtungen an definierten Abholpositionen bereitgestellt. Ein durch ein Positioniersystem verfahrbarer Bestückkopf des Bestückautomaten holt die Bauelemente an den Abholpositionen ab und transferiert sie zu einem Bestückbereich des Bestückautomaten, wo sie auf bereitgestellten Substraten positioniert werden. Zu bestückende Substrate werden über eine Transporteinrichtung dem Bestückbereich zugeführt, fertig bestückte Substrate werden über diese Transporteinrichtung wieder aus dem Bestückbereich heraustransportiert. Ein derartiger Bestückautomat ist beispielsweise aus der Patentschrift DE 10336609 B3 bekannt.

Ferner ist aus der Patentschrift DE 102 36 604 B4 ein Bestückkopf mit mehreren Greifern bekannt, welcher eine Längs- bzw. eine Querführung für einen darin verschiebbaren Längs- bzw. Querschlitten aufweist, wobei einer der Greifer an dem Längsschlitten und der andere Greifer an dem Querschlitten befestigt ist, so dass sie parallel zu einer Substratebene verschiebbar sind.

Es ist die Aufgabe der vorliegenden Erfindung, einen Bestückkopf, einen Bestückautomaten, sowie Verfahren zum Abholen von Bauelementen bzw. zum Bestücken von Substraten bereitzustellen, mittels derer die Bestückleistung erhöht werden kann.

Diese Aufgabe wird durch den Bestückkopf, den Bestückautomaten sowie das Verfahren zum Abholen von Bauelementen bzw. zum Bestücken von Substraten gemäß den unabhängigen Ansprüchen gelöst. Vorteilhafte Ausgestaltungen sind Gegenstand der abhängigen Ansprüche.

Der erfindungsgemäße Bestückkopf zum Bestücken von Substraten mit Bauelementen für einen Bestückautomaten weist mindestens einen ersten und einen zweiten Pipettenträger auf, welche zum Aufnehmen von Pipetten ausgestaltet sind, wobei zumindest der erste Pipettenträger mehrere Pipetten zum Handhaben der Bauelemente aufweist. Die Pipetten sind an ihrem jeweiligen Pipettenträger in einer Ebene parallel zu einer Ebene des Substrats angeordnet und relativ zu ihrem jeweiligen Pipettenträger entlang ihrer jeweiligen Achse in einer z-Richtung senkrecht zur Ebene des Substrats verschiebbar sowie um diese jeweilige Achse drehbar. Zumindest der erste Pipettenträger ist dabei um eine Drehachse, welche senkrecht zur Ebene des Substrats orientiert ist, drehbar.

Mit Hilfe eines derart gestalteten Bestückkopfs ist es möglich, zumindest eine Pipette relativ zum Bestückkopf in einer Ebene parallel zur Ebene des Substrats zu bewegen und auf diese Weise zumindest zwei Pipetten, welche an verschiedenen Pipettenträgern angeordnet sind, relativ zueinander zu positionieren. Damit ist es möglich, mehrere Bauelemente gleichzeitig zu handhaben, beispielsweise von ihren Abholpositionen abzuholen. Die Bauelemente werden mit Hilfe sogenannter Zuführeinrichtungen des Bestückautomaten an definierten Abholpositionen bereitgestellt. Durch eine Überlagerung mit der Verfahrbewegung des Bestückkopfs mit der Positionierbewegung zweier Pipetten relativ zueinander ist es somit möglich, mittels einer Zustellbewegung in z-Richtung, senkrecht zur Ebene des Substrats, mindestens zwei Bauelemente gleichzeitig von ihren Abholpositionen abzuholen. Hierbei ist zu beachten, dass der Teilungsabstand der Abholpositionen dem Abstand derjenigen Pipetten entspricht, welche die Bauelemente aufnehmen sollen. Der Zeitanteil für das Aufnehmen der Bauelemente kann dadurch deutlich verkürzt werden, was eine höhere Bestückleistung des Bestückautomaten ermöglicht.

In einer vorteilhaften Ausgestaltung des Bestückkopfs ist der Bestückkopf an einem Positioniersystem des Bestückautomaten linear verfahrbar angeordnet, so dass ein relativ zum Bestückautomaten feststehendes Substrat bei gleichzeitig relativ zum Bestückautomaten festgehaltenem Positioniersystem zumindest streifenweise bestückbar ist.

Unter der "streifenweisen Bestückung" ist dabei zu verstehen, dass ein Streifen des Substrats, d.h. ein Bereich mit einer von Null verschiedenen Breite, bei ruhendem Substrat und festgehaltenem Positioniersystem mit Hilfe des erfindungsgemäßen Bestückkopfs bestückt werden kann. Daraus ergibt sich der Vorteil, dass die Positionierung der einzelnen Bauelemente innerhalb eines Streifens des Substrats ausschließlich durch Positionierbewegungen des Bestückkopfs erfolgen kann - weder das Substrat noch das Positioniersystem selbst müssen dabei bewegt werden. Demnach muss nicht jede Bestückposition auf dem Substrat mittels einer Relativbewegung zwischen dem Positioniersystem und dem Substrat einzeln angesteuert werden. Vielmehr ist es ausreichend, das Positioniersystem sowie das Substrat derart relativ zueinander zu positionieren, dass allein durch die Positionierbewegungen des Bestückkopfs mehrere Bestückpositionen auf dem Substrat mit Bauelementen bestückbar sind. Indem Verfahrbewegungen des Positioniersystems vermieden werden und lediglich der Bestückkopf (und damit eine deutlich geringere Masse) bewegt wird, lassen sich Schwingungen, welche aus der Beschleunigung des Positioniersystems resultieren, deutlich reduzieren. Die Bestückgenauigkeit wird dadurch deutlich verbessert.

Das Positioniersystem ist dabei entweder verfahrbar oder auch als feststehende Linearführung für den Bestückkopf ausgebildet. Voraussetzung für das streifenweise Bestücken ist lediglich, dass das Positioniersystem während des Bestückens des Steifens mit mehreren Bauelementen ruht. Das streifenweise Bestücken erfolgt dann ausschließlich durch die lineare Verfahrbewegung des Bestückkopfs am Positioniersystem sowie durch die Verstellmöglichkeiten einzelner Pipetten oder Pipettenträger quer zur Verfahrrichtung des Bestückkopfs.

Gegenüber einer herkömmlichen Split-Axes Bestückung, bei denen unter anderem das Substrat für die Positionierung eines jeden Bauelements verfahren werden muss, resultiert hieraus der Vorteil, dass beim Bestücken eines Streifens das Substrat ruht, so dass bereits bestückte Bauelemente nicht durch die Verfahrbewegungen des Substrats verrutschen können.

Geometrisch betrachtet kann die "streifenweise Bestückung" derart definiert werden, dass mehrere Bauelemente auf ihre Bestückpositionen innerhalb eines zu bestückenden Streifens des Substrats positioniert werden können, wobei die Bestückpositionen einen unterschiedlichen Abstand zu einer senkrechten Projektion der Verfahrachse des Bestückkopfs auf das Substrat aufweisen dürfen. Die Breite des Streifens ist dabei durch den maximalen Aktionsradius der Pipetten begrenzt.

In einer weiteren vorteilhaften Ausgestaltung des Bestückkopfs ist die Drehachse relativ zum jeweiligen Pipettenträger außermittig angeordnet, so dass der jeweilige Pipettenträger in einer Ebene parallel zur Ebene des Substrats schwenkbar ist.

Eine Schwenkachse für den Pipettenträger stellt eine einfache Möglichkeit dar, die am Pipettenträger angeordneten Pipetten in einer Ebene parallel zur Ebene des Substrats zu bewegen, ohne dabei Linearachsen oder -führungen verwenden zu müssen.

Unter dem Begriff außermittig ist dabei zu verstehen, dass die Schwenkachse, welche senkrecht zur Ebene des Substrats orientiert ist, in einer Schnittebene parallel zur Ebene des Substrats entweder in einem Randbereich des Pipettenträgers oder vollständig außerhalb des Umrisses des Pipettenträgers angeordnet ist. Im Falle eines rotationssymmetrischen Pipettenträgers ist die Schwenkachse keinesfalls im Schnittpunkt der Symmetrieachsen des Pipettenträgers angeordnet.

In einer weiteren vorteilhaften Ausgestaltung des Bestückkopfs ist zumindest einer der Pipettenträger zumindest in einer Richtung parallel zur Ebene des Substrats am Bestückkopf relativ zum anderen Pipettenträger linear verfahrbar.

Der durch die Linearbewegung eines der beiden Pipettenträger realisierte, zusätzliche Freiheitsgrad ermöglicht eine unabhängige Positionierung zweier Pipetten, welche an verschiedenen Pipettenträgern angeordnet sind. Damit ist es möglich, zumindest zwei von den Pipetten gehaltene Bauelemente derart in einer Ebene parallel zur Ebene des Substrats zu positionieren, dass sie mittels einer Zustellbewegung in z-Richtung gleichzeitig auf ihre Bestückpositionen auf dem Substrat abgesetzt werden können. Dadurch kann der Zeitanteil für das Bestücken des Substrats deutlich reduziert werden, was wiederum die Bestückleistung des Bestückautomaten deutlich erhöht.

In einer weiteren vorteilhaften Ausgestaltung des Bestückkopfs weist jeder Pipettenträger einen z-Antrieb zum Bewegen zumindest einer der Pipetten entlang ihrer jeweiligen Achse in z-Richtung auf, wobei der z-Antrieb dabei an zumindest eine beliebige Pipette des jeweiligen Pipettenträgers ankoppelbar ist.

Mit Hilfe des z-Antriebs ist es möglich, eine einzelne Pipette gezielt in z-Richtung senkrecht zur Ebene des Substrats abzusenken und/oder anzuheben. Der z-Antrieb kann dazu mit der jeweiligen Pipette gekoppelt werden. Dadurch wird die in z-Richtung beschleunigte Masse deutlich reduziert, was zu einem verbesserten Schwingungsverhalten und damit zu einer höheren Bestückgenauigkeit führt. Ferner sind durch die geringere bewegte Masse höhere Beschleunigungen möglich, was sich positiv auf die Bestückleistung auswirkt.

In einer weiteren vorteilhaften Ausgestaltung des Bestückkopfs ist jeder Pipette eines Pipettenträgers ein eigener, separat ansteuerbarer z-Antrieb zugeordnet, welcher eine Bewegung der jeweiligen Pipette in z-Richtung ermöglicht.

Indem jede Pipette einen eigenen, individuell ansteuerbaren z-Antrieb aufweist, können die Achsen der einzelnen Pipetten während der Verfahrbewegung des Bestückkopfs bereits in z-Richtung vorpositioniert werden. Durch diese Parallelisierung der Verfahrbewegung des Bestückkopfs einerseits mit der Zustellbewegung der Pipetten in z-Richtung andererseits kann die Bestückleistung weiter erhöht werden.

In einer weiteren vorteilhaften Ausgestaltung des Bestückkopfs ist jeder Pipette eines Pipettenträgers ein eigener, separat ansteuerbarer Drehantrieb zugeordnet, welcher eine Drehbewegung der jeweiligen Pipette um ihre jeweilige Achse ermöglicht.

Indem jeder Pipette ein eigener, individuell ansteuerbarer Drehantrieb zugeordnet ist, kann bereits während der Verfahrbewegung des Bestückkopfs oder auch während der Vorpositionierung der Pipette in z-Richtung eine Korrektur der Winkellage des gehaltenen Bauelements um die jeweilige z-Achse der Pipette erfolgen. Die Bestückleistung kann dadurch weiter erhöht werden.

In einer weiteren vorteilhaften Ausgestaltung des Bestückkopfs weist zumindest der erste Pipettenträger einen Stator sowie einen um die Drehachse drehbaren Rotor auf, an dem die mindestens zwei Pipetten angeordnet sind.

Mit Hilfe eines derartigen, horizontal drehenden Pipettenträgers mit einem um die senkrecht zur Substratebene orientierte Drehachse drehbaren Rotor, können die an dem Pipettenträger in z-Richtung verschiebbar angeordneten Pipetten in einer Ebene parallel zur Ebene des Substrats relativ zum Bestückkopf bewegt und damit relativ zu einer Pipette des anderen Pipettenträgers positioniert werden. Durch eine Überlagerung dieser Bewegung mit der Verfahrbewegung des Bestückkopfs ist es möglich, zumindest zwei Pipetten derart zu positionieren, dass mehrere Bauelemente gleichzeitig von ihren Abholpositionen abgeholt oder auf dem Substrat abgesetzt werden können. Ferner ist es möglich, die Pipetten innerhalb eines Streifens über dem Substrat derart zu positionieren, dass das Substrat streifenweise bestückt werden kann. Die Breite des Streifens entspricht dabei der doppelten Breite des Abstands der Halteeinrichtungen zur Drehachse des Rotors.

In einer weiteren vorteilhaften Ausgestaltung des Bestückkopfs weist zumindest der erste Pipettenträger mehrere Pipetten auf, welche in einer Reihe geradlinig angeordnet sind, so dass der Pipettenträger mittels der außermittig angeordneten Drehachse in einer Ebene parallel zur Ebene des Substrats schwenkbar ist.

Auch durch das Schwenken eines Pipettenträgers, bei dem mehrere Pipetten in einer Reihe angeordnet sind, um die Drehachse, welche senkrecht zur Ebene des Substrats orientiert ist, ist es möglich, die am Pipettenträger angeordneten Pipetten in einer Ebene parallel zur Ebene des Substrats zu bewegen.

Vorteilhafter Weise ist die Drehachse dabei relativ zum Pipettenträger außermittig angeordnet. Hierdurch kann der "Aktionsradius" der einzelnen Pipetten um die Drehachse vergrößert werden, was eine höhere Flexibilität bei der relativen Positionierung mehrerer Pipetten verschiedener Pipettenträger erlaubt. Hinsichtlich der weiteren Vorteile wird auf die obigen Ausführungen zum horizontal drehenden Pipettenträger verwiesen.

Der erfindungsgemäße Bestückautomat zum Bestücken von Substraten mit Bauelementen weist ein Positioniersystem, das an einem Chassis des Bestückautomaten angeordnet und zum Aufnehmen zumindest eines Bestückkopfs ausgebildet ist, sowie einen ersten Bestückkopf nach einem der Ansprüche 1 bis 9 auf.

Hinsichtlich der Vorteile eines derartigen Bestückautomaten wird auf die obigen Ausführungen zu den Vorteilen des erfindungsgemäßen Bestückkopfs verwiesen.

In einer vorteilhaften Ausgestaltung des Bestückautomaten ist das Positioniersystem als feststehendes Portal ausgebildet, welches fest mit dem Chassis verbunden ist, so dass der Bestückkopf mittels des Positioniersystems ausschließlich linear verfahrbar ist.

Da es zur Positionierung einer einzelnen Pipette nicht explizit notwendig ist, das Positioniersystem verfahrbar auszubilden, kann eine einfache Ausführungsform, bei der das Positioniersystem als feststehendes Portal oder Führungselement ausgebildet ist, als kostengünstige Realisierungsmöglichkeit gewählt werden. Das Positioniersystem ist dabei gegenüber einem Maschinengrundkörper des Bestückautomaten nicht mehr verfahrbar. Alle Positionierbewegungen innerhalb eines zu bestückenden Streifens des Substrats werden durch eine lineare Verfahrbewegung des Bestückkopfs am feststehenden Positioniersystem sowie durch Bewegungen der Pipetten und/oder Pipettenträger am Bestückkopf ausgeführt. Zur Bestückung eines weiteren Streifens des Substrats wird dieses quer, vorzugsweise orthogonal, zur Verfahrrichtung des Bestückkopfs am Positioniersystem weiter verfahren.

In einer weiteren vorteilhaften Ausgestaltung des Bestückautomaten sind mehrere Bauelemente gleichzeitig auf dem Substrat positionierbar.

Die Verwendung des erfindungsgemäßen Bestückkopfs erlaubt in einer Ebene parallel zur Ebene des Substrats eine Positionierung mehrerer Pipetten relativ zueinander. Damit ist ein gleichzeitiges Absetzen mehrerer Bauelemente auf dem Substrat möglich. Die Bestückleistung des Bestückautomaten kann dadurch deutlich erhöht werden.

In einer weiteren vorteilhaften Ausgestaltung des Bestückautomaten ist mindestens ein weiterer Bestückkopf an dem Positioniersystem verfahrbar angeordnet. Jedem der Bestückköpfe ist dabei eine eigene Antriebseinheit zugeordnet, welche eine voneinander unabhängige Bewegung der Bestückköpfe an dem Positioniersystem ermöglichen.

Durch die Verwendung eines weiteren Bestückkopfs, welcher an demselben Positioniersystem unabhängig vom ersten Bestückkopf verfahren werden kann, wird die Anzahl an einsetzbaren Pipetten erhöht, ohne dass hierfür ein weiteres Positioniersystem erforderlich wäre. Damit kann ohne großen konstruktiven Aufwand die Bestückleistung weiter erhöht werden.

Bei dem erfindungsgemäßen Verfahren zum Abholen von Bauelementen mit Hilfe eines Bestückkopfs, der nach einem der Ansprüche 1 bis 9 für einen Bestückautomaten ausgebildet ist, welcher Zuführeinrichtungen aufweist, mittels derer die Bauelemente an Abholpositionen bereitgestellt werden, werden Pipetten mehrerer Pipettenträger derart vorpositioniert, dass mehrere Bauelemente gleichzeitig durch eine Zustellbewegung der jeweiligen Pipetten in einer z-Richtung senkrecht zu einer Ebene des Substrats von ihren jeweiligen Abholpositionen abgeholt werden.

Bei dem weiteren erfindungsgemäßen Verfahren zum Bestücken von Substraten mit Bauelementen mit Hilfe eines Bestückkopfs, der nach einem der Ansprüche 1 bis 9 für einen Bestückautomaten ausgebildet ist, werden Pipetten mehrerer Pipettenträger des Bestückkopfs derart vorpositioniert, dass mehrere von den Pipetten gehaltene Bauelemente gleichzeitig auf dem Substrat positioniert werden.

Sowohl das gleichzeitige Abholen mehrerer Bauelemente von ihren jeweiligen Abholpositionen als auch das gleichzeitige Positionieren mehrerer Bauelemente auf ihren jeweiligen Bestückpositionen auf dem Substrat führen zu einer deutlichen Steigerung der Bestückleistung des erfindungsgemäßen Bestückautomaten. Hinsichtlich der weiteren Vorteile der beiden erfindungsgemäßen Verfahren wird auf die vorangehenden Ausführungen zu dem erfindungsgemäßen Bestückkopf bzw. zu dem erfindungsgemäßen Bestückautomaten verwiesen.

Im Folgenden wird ein Ausführungsbeispiel des erfindungsgemäßen Bestückkopfs bzw. des erfindungsgemäßen Bestückautomaten unter Bezug auf die beigefügten Figuren näher erläutert. Dabei zeigt:
- Fig. 1: eine schematische Darstellung eines Bestückautomaten in einer Draufsicht,
- Fig. 2a und 2b: Schematische Darstellungen einer ersten Ausführungsform des erfindungsgemäßen Bestückkopfs mit zwei Pipettenträgern in Grund- und Aufriss,
- Fig. 3a und 3b: schematische Darstellungen einer zweiten Ausführungsform des erfindungsgemäßen Bestückkopfs mit zwei Pipettenträgern in Grund- und Aufriss,
- Fig. 4a und 4b: schematische Darstellungen einer dritten Ausführungsform des erfindungsgemäßen Bestückkopfs mit zwei Pipettenträgern in Grund- und Aufriss,
- Fig. 5a, 5b und 5c: schematische Darstellungen verschiedener Ausführungsformen des erfindungsgemäßen Bestückkopfs mit mehr als zwei Pipettenträgern, und
- Fig. 6a und 6b: schematische Darstellungen des erfindungsgemäßen Bestückautomaten im Grundriss,

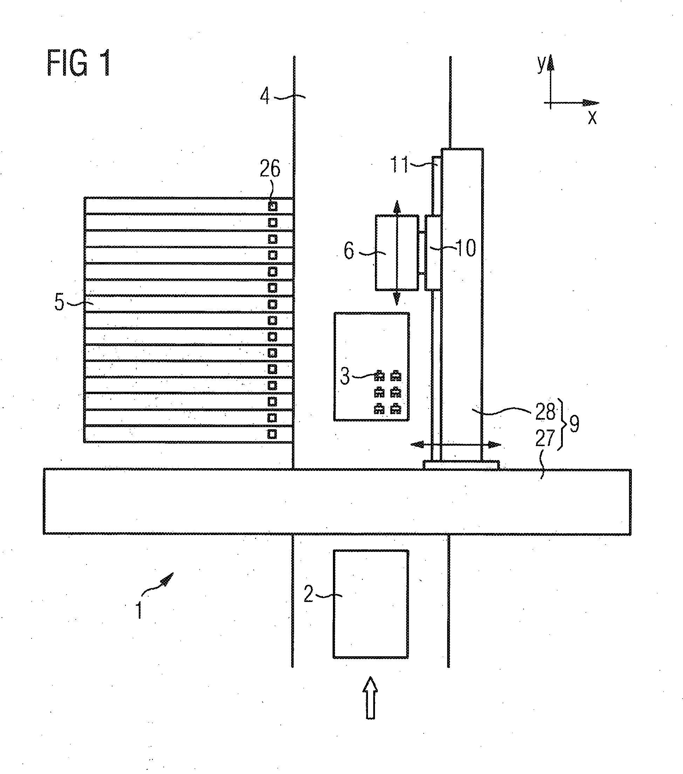

Figur 1 zeigt schematisch den allgemeinen Aufbau eines Bestückautomaten 1 zum Bestücken von Substraten 2 mit Bauelementen 3, welcher zur Aufnahme des erfindungsgemäßen Bestückkopfs 6 geeignet ist. Der Bestückautomat 1 weist einen Querträger 27 auf, welcher sich in einer y-Richtung erstreckt und fest mit einem Maschinengestell (nicht dargestellt) verbunden ist. Am Querträger 27 ist ein Portalarm 28 angebracht, welcher sich in x-Richtung erstreckt und in y-Richtung verschiebbar am Querträger 27 befestigt ist. Querträger 27 und Portalarm 28 bilden zusammen das Positioniersystem 9, wobei durch die x-Achse und die y-Achse ein orthogonales Bezugssystem gebildet wird. Am Portalarm 28 ist ein Bestückkopf 6 in x-Richtung verschiebbar angebracht, welcher kann mit Hilfe einer Antriebseinheit 10 in x-Richtung entlang eines am Portalarm 28 angeordneten Führungselements 11 definiert bewegt werden kann. Weiterhin ist eine Transportstrecke 4 zum Transport der Substrate 2 in einen Bestückbereich des Bestückautomaten 1 vorgesehen. Seitlich der Transportstrecke 4 sind in der Nähe des Bestückbereichs Zuführvorrichtungen 5 angeordnet, welche die Bauelemente 3 an ihren jeweiligen Abholpositionen 26 bereitstellen.

Zum Bestücken eines Substrats 2 wird dieses über die Transportstrecke 4 in den Bestückbereich transportiert. Die von der Zuführvorrichtung 5 bereitgestellten elektrischen Bauelemente 3 werden von dem Bestückkopf 6 abgeholt und in den Bestückbereich transferiert, wo sie auf ihren jeweiligen Bestückpositionen auf dem Substrat 2 positioniert werden.

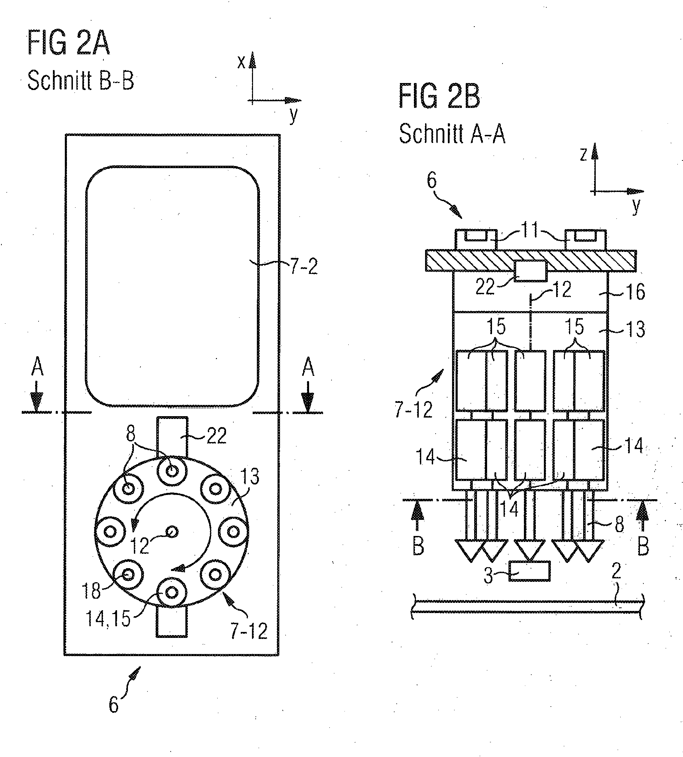

Die Figuren 2 bis 4 zeigen mehrere Ausführungsformen des erfindungsgemäßen Bestückkopfs 6 mit jeweils zwei Pipettenträgern 7. Dabei ist in allen drei Ausführungsformen jeweils nur der erste Pipettenträger 7-1x konkret ausgeführt, der zweite Pipettenträger 7-2 ist lediglich schematisiert dargestellt und kann beliebig ausgeführt sein. Da der erste Pipettenträger 7-1x in den Figuren 2 bis 4 unterschiedlich ausgeführt ist, bezieht sich die letzte Ziffer des jeweiligen Bezugszeichens auf die jeweilige Figur. Wird der erste Pipettenträger allgemein adressiert, so ist dies durch den Platzhalter x kenntlich gemacht.

Allen drei dargestellten Ausführungsformen ist gemein, dass der erste Pipettenträger 7-1x mehrere Pipetten 8 aufweist, welche an dem ersten Pipettenträger 7-1x in einer x/y-Ebene angeordnet sind. Die x/y-Ebene ist dabei parallel zu einer Substratebene, welche durch die Oberfläche des zu bestückenden Substrats 2, auf der die Bauelemente 3 abgesetzt werden, bestimmt wird. Die einzelnen Pipetten 8 sind entlang einer z-Richtung senkrecht zur Substratebene verschiebbar sowie um ihre jeweilige Pipettenachse 18 drehbar, so dass von den Pipetten gehaltene Bauelemente 3 hinsichtlich ihrer Winkellage positionierbar sind und auf dem Substrat 2 abgesetzt werden können. Hierzu sind jeder Pipette 8 ein eigener z-Antrieb 15 sowie ein eigener Drehantrieb 14 zugeordnet. Es ist jedoch auch möglich, einen für alle Pipetten 8 gemeinsamen Drehantrieb zu verwenden, wobei jeweils dasjenige Bauelement 3 hinsichtlich seiner Winkellage positioniert wird, das als nächstes auf das Substrat 2 abgesetzt werden soll. Ferner ist es möglich, einen gemeinsamen z-Antrieb zu verwenden, an den eine oder mehrere Pipetten 8 angekoppelt werden können. Der erste Pipettenträger 7-1x weist ferner noch eine Drehachse 12 auf, welche ebenfalls in z-Richtung senkrecht zur Substratebene orientiert ist. Damit kann der erste Pipettenträger 7-1x mit den daran angeordneten Pipetten in einer Ebene parallel zur Ebene des Substrats 2 gedreht bzw. geschwenkt werden. Mit Hilfe von Führungselementen 11 wird der Bestückkopf 6 an dem Positioniersystem 9 (siehe Figur 1) des Bestückautomaten 1 geführt.

Die Figuren 2a und 2b zeigen eine erste Ausführungsform des Bestückkopfs 6, wobei Figur 2a eine Schnittdarstellung entlang der Linie B-B, und Figur 2b eine Schnittdarstellung entlang der Linie A-A zeigen. Der erste Pipettenträger 7-12 ist dabei horizontal drehend ausgebildet und weist einen Stator 16 sowie einen Rotor 13 auf, an dem die einzelnen Pipetten 8 angeordnet sind. Während der Stator 16 fest am Bestückkopf 6 angeordnet ist, ist der Rotor 13 um eine Drehachse 12 drehbar gelagert. Damit können die Pipetten 8 in einer Ebene parallel zur Substratebene bewegt werden.

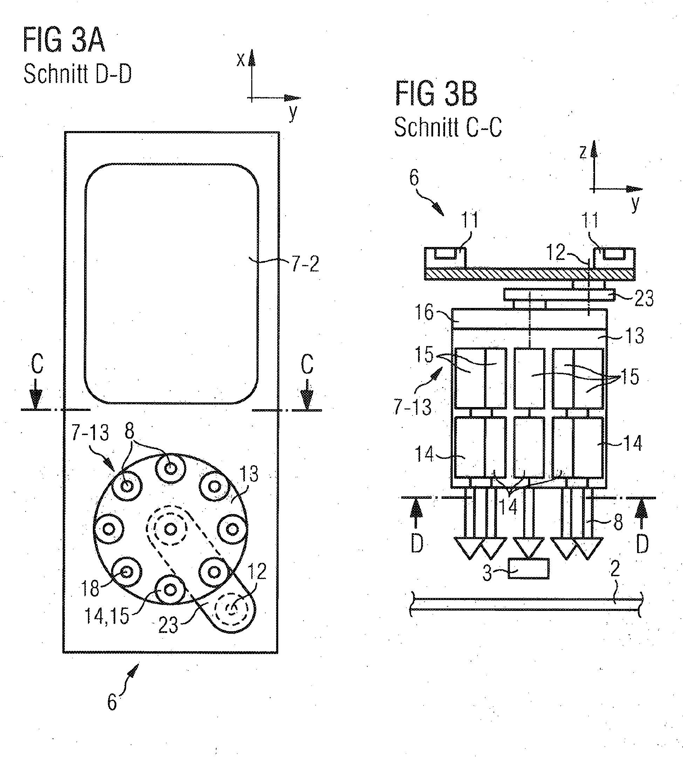

Die Figuren 3a und 3b zeigen eine zweite Ausführungsform des Bestückkopfs 6, wobei Figur 3a eine Schnittdarstellung entlang der Linie D-D, und Figur 3b eine Schnittdarstellung entlang der Linie C-C zeigen. Der erste Pipettenträger 7-13 ist wiederum horizontal drehend ausgebildet und weist dementsprechend ebenfalls einen Stator 16 sowie einen um den Stator drehenden Rotor 13 auf, an dem die Pipetten 8 angeordnet sind. Jedoch ist im Unterschied zu der in den Figuren 2a und 2b dargestellten ersten Ausführungsform die Drehachse 12 außermittig angeordnet, so dass der erste Pipettenträger 7-13 mittels eines Schwenkarms 23 um diese Drehachse 12 geschwenkt werden kann. Hierdurch wird der Aktionsradius, innerhalb dessen die einzelnen Pipetten 8 relativ zum Bestückkopf 6 bewegt werden können, deutlich vergrößert. Dies ist insbesondere für das streifenweise Bestücken von Substraten 2, bei dem mehrere Bauelemente 3 auf dem Substrat 2 abgesetzt werden können, ohne zwischenzeitlich das Positioniersystem 9 oder das Substrat 2 verfahren zu müssen, von Vorteil.

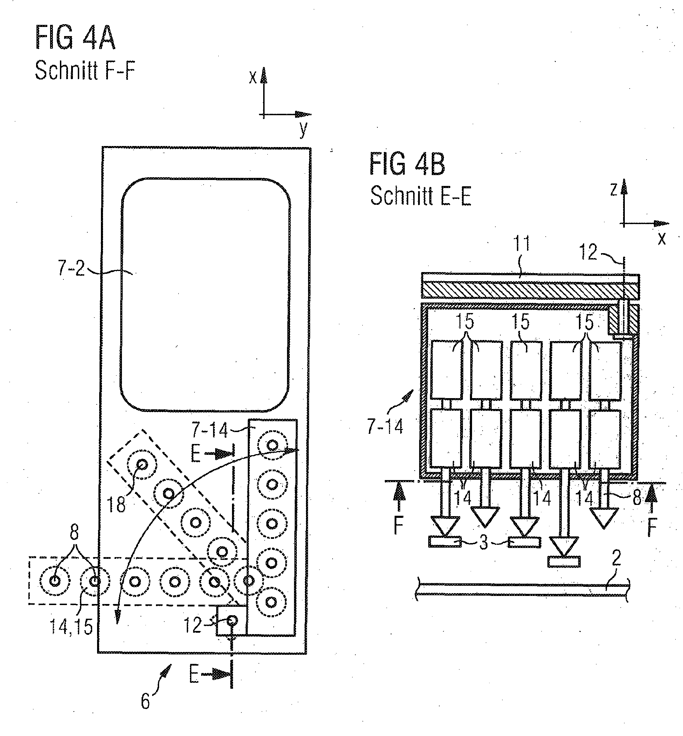

Die Figuren 4a und 4b zeigen eine dritte Ausführungsform des Bestückkopfs 6, wobei Figur 4a eine Schnittdarstellung entlang der Linie F-F, und Figur 4b eine Schnittdarstellung entlang der Linie E-E zeigen. Die einzelnen Pipetten 8 des ersten Pipettenträgers 7-14 sind dabei geradlinig in einer Reihe angeordnet. Der erste Pipettenträger 7-14 selbst ist um die Drehachse 12, drehbar, so dass die einzelnen Pipetten 8 in der x/y-Ebene, parallel zur Substratebene, bewegt werden können. Neben einer ersten Stellung ist der erste Pipettenträger 7-14 in Figur 4a noch in zwei weiteren möglichen Stellungen, die sich aus einer Drehung um die Drehachse 12 ergeben, gestrichelt dargestellt.

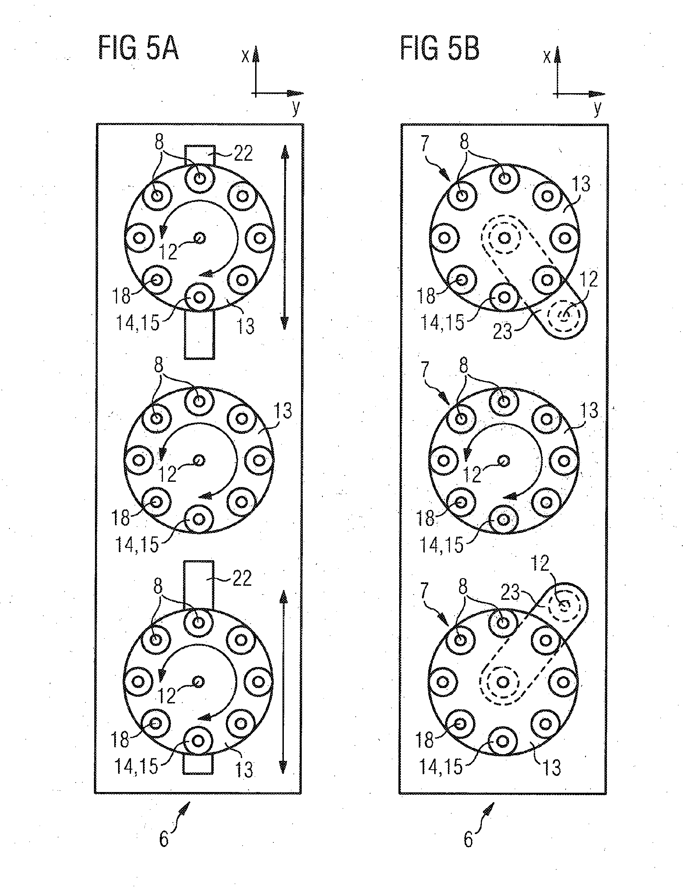

Die Figuren 5a bis 5c zeigen weitere Ausführungsformen des erfindungsgemäßen Bestückkopfs 6, welche mehr als zwei Pipettenträger 7 aufweisen.

Figur 5a zeigt einen Bestückkopf 6 mit drei horizontal drehenden Pipettenträgern 7, welche hinsichtlich ihres konstruktiven Aufbaus dem aus den Figuren 2a und 2b bekannten ersten Pipettenträger 7-12 entsprechen. Alle drei Pipettenträger 7 weisen einen um eine Drehachse 12 drehbaren Rotor 13 auf, an dem die einzelnen Pipetten 8 angeordnet sind. Die einzelnen Pipetten 8 sind entlang einer z-Richtung senkrecht zur x/y-Ebene verschiebbar sowie um ihre jeweilige Pipettenachse 18 drehbar. Hierzu sind jeder Pipette 8 ein eigener Drehantrieb 14 sowie ein eigener z-Antrieb 15 zugeordnet. Während der mittlere Pipettenträger 7 ortsfest am Bestückkopf 6 angeordnet ist, sind die beiden äußeren Pipettenträger 7 entlang einer Linearführung 22 relativ zum Bestückkopf 6 verschiebbar. Dieser zusätzliche Freiheitsgrad ermöglicht eine unabhängige Positionierung zweier Pipetten, welche an verschiedenen Pipettenträgern angeordnet sind. Während die relative Positionierung der beiden Pipetten 8 in y-Richtung durch eine Drehbewegung der jeweiligen Pipettenträger 7 erreicht wird, erfolgt die Positionierung in x-Richtung durch eine entsprechende Verfahrbewegung des jeweiligen Pipettenträgers 7 entlang der jeweiligen Linearführung 22. Damit können auch Bauelemente 3, deren Bestückpositionen auf dem Substrat 2 unmittelbar benachbart zueinander angeordnet sind, gleichzeitig oder unmittelbar nacheinander auf dem Substrat 2 abgesetzt werden, ohne dass hierzu der gesamte Bestückkopf 6 zwischenzeitlich bewegt werden muss.

Figur 5b zeigt eine weitere Ausführungsform des erfindungsgemäßen Bestückkopfs 6 mit ebenfalls drei horizontal drehenden Pipettenträgern 7. Während der mittlere Pipettenträger 7 wiederum ortsfest am Bestückkopf 6 angeordnet ist, entsprechen die beiden äußeren Pipettenträger 7 hinsichtlich ihres konstruktiven Aufbaus dem aus den Figuren 3a und 3b bekannten ersten Pipettenträger 7-13. Beide weisen eine außermittig angeordnete Drehachse 12 auf, um die der jeweilige Pipettenträger 7 geschwenkt werden kann. Da durch die Schwenkbewegung auch eine Relativbewegung der einzelnen Pipettenträger 7 zueinander realisierbar ist, ist für diese Ausführungsform keine zusätzliche Linearführung 22 wie in der in Figur 5a dargestellten Ausführungsform erforderlich.

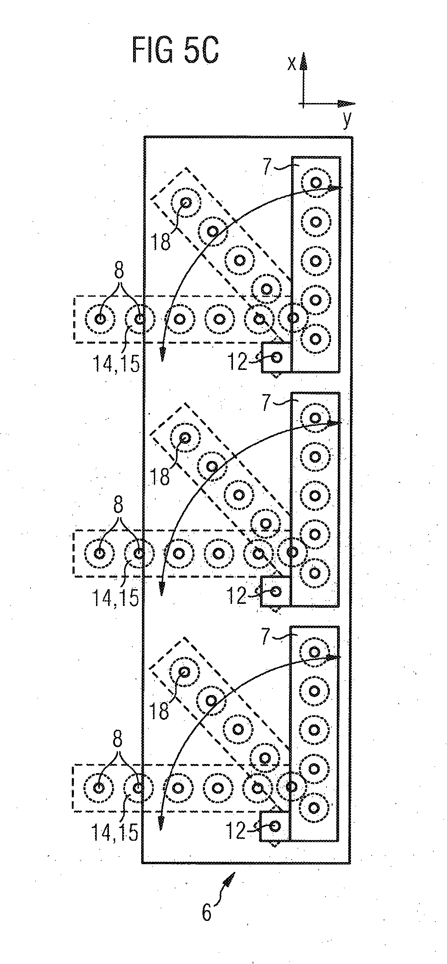

Figur 5c zeigt eine dritte Ausführungsform des erfindungsgemäßen Bestückkopfs 6 mit ebenfalls drei Pipettenträgern 7, deren Pipetten 8 jeweils geradlinig in einer Reihe angeordnet sind. Hinsichtlich ihres konstruktiven Aufbaus sind die drei Pipettenträger 7 identisch und entsprechen dem aus den Figuren 4a und 4b bekannten ersten Pipettenträger 7-14. Die Pipettenträger 7 sind jeweils um ihre im Randbereich des jeweiligen Pipettenträgers angeordnete und in z-Richtung orientierte Drehachse 12 drehbar, so dass die einzelnen Pipetten 8 des jeweiligen Pipettenträgers 7 in der x/y-Ebene, parallel zur Substratebene, bewegt werden können. Durch diese Schwenkbewegung ist eine unabhängige Positionierung mehrerer Pipetten 8, welche an unterschiedlichen Pipettenträgern 7 angeordnet sind, zumindest in der y-Richtung möglich. Neben einer ersten Stellung ist jeder der Pipettenträger 7 noch in zwei weiteren möglichen Stellungen, die sich aus einer Drehung um die Drehachse 12 um 45° bzw. 90° ergeben, gestrichelt dargestellt. Entspricht darüber hinaus der Teilungsabstand der am jeweiligen Pipettenträger 7 angeordneten Pipetten 8 dem Teilungsabstand der Abholpositionen 26 der Zuführeinrichtungen 5 (siehe Figur 1), und weisen die einzelnen Pipettenträger 7 einen Abstand zueinander auf, der einem ganzzahligen Vielfachen dieses Teilungsabstands entspricht, so ist es ferner möglich, dass bei einer entsprechenden Positionierung des Bestückkopfs 6 alle Pipetten 8 gleichzeitig Bauelemente 3 von ihren jeweiligen Abholpositionen 26 abholen.

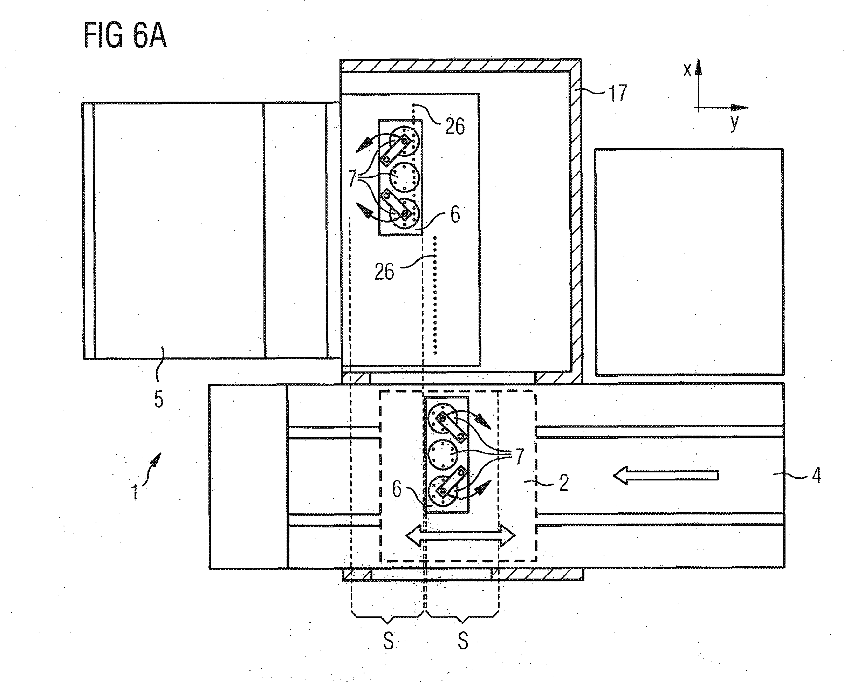

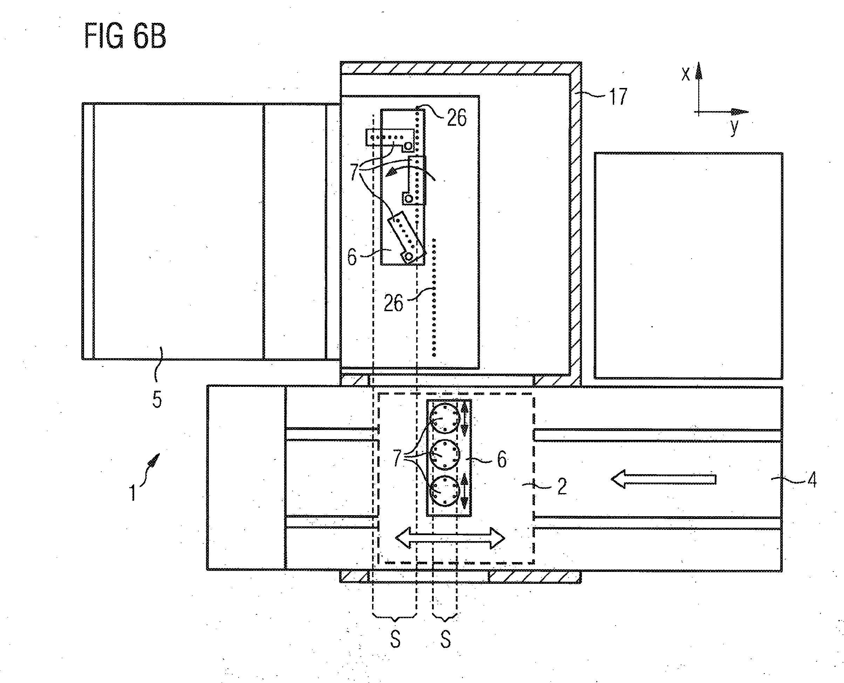

Die Figuren 6a und 6b zeigen jeweils eine Schnittdarstellung des erfindungsgemäßen Bestückautomaten (1) in einer Draufsicht, wobei die Schnittebene unterhalb des Positioniersystems 9 (siehe Figur 1) gelegt wurde, so dass die Bestückköpfe 6 nicht durch das Positioniersystem 9 verdeckt werden. Das Positioniersystem 9 kann dabei als feststehendes Portal ausgebildet sein, welches fest mit einem Chassis 17 des Bestückautomaten 1 verbunden ist, so dass die die beiden Bestückköpfe 6 lediglich in x-Richtung am Portal verfahrbar angeordnet sind. Vorteilhafter Weise werden die beiden Bestückköpfe 6 dabei am Positioniersystem 9 hängend geführt. Es ist jedoch ebenso möglich, das Positioniersystem 9 als Querträger 27 mit einem verfahrbaren Portalarm 28 auszubilden (siehe Figur 1).

Der Bestückautomat 1 verfügt ferner über eine Transportstrecke 4 zum Transport von Substraten 2 in einer y-Richtung. Weiterhin weist der Bestückautomat 1 Zuführeinrichtungen 5 auf, mittels derer die Bauelemente 3 an definierten Abholpositionen 26 zur Abholung durch einen Bestückkopf 6 bereitgestellt werden. Die beiden in den Figuren 6a und 6b dargestellten Bestückautomaten 1 unterscheiden sich lediglich in der Ausführungsform der montierten Bestückköpfe 6.

In Figur 6a ist der Bestückautomat 1 mit zwei identischen Bestückköpfen 6 ausgerüstet, wie sie bereits aus Figur 5b bekannt sind. Um den Bereich zwischen den beiden Bestückköpfen 6 möglichst zu minimieren, sind die beiden Bestückköpfe 6 spiegelbildlich zueinander an einem gemeinsamen Positioniersystem 9 (nicht dargestellt) in x-Richtung linear verfahrbar angeordnet. Beide Bestückköpfe 6 weisen jeweils drei Pipettenträger 7 auf, von denen jeweils die beiden äußeren schwenkbar am Bestückkopf 6 angeordnet sind. Dadurch ist es möglich, einen deutlich breiteren Streifen S des Substrats 2 streifenweise zu bestücken, d.h. ausschließlich durch Positionierbewegungen des Bestückkopfs 6, ohne dabei das Positioniersystem 9 oder das Substrat 2 verfahren zu müssen.

Der in Figur 6b dargestellte Bestückautomat 1 ist mit zwei unterschiedlichen Bestückköpfen 6 ausgerüstet. Einer der beiden Bestückköpfe 6 weist dabei drei horizontal drehende Pipettenträger 7 auf und ist bereits aus der Beschreibung zu Figur 5a bekannt. Der andere Bestückkopf 6 weist drei schwenkbare Pipettenträger 7 auf, deren Pipetten 8 jeweils geradlinig in einer Reihe angeordnet sind, und ist bereits aus der der Beschreibung zu Figur 5c bekannt. Auch mit dieser Konfiguration ist es möglich, mehrere Bauelemente 3 gleichzeitig zu handhaben bzw. ein Substrat 2 streifenweise zu bestücken.

Anhand der Figuren 6a und 6b werden im Folgenden das erfindungsgemäße Verfahren zum Abholen von Bauelementen 3 sowie das erfindungsgemäße Verfahren zum Bestücken von Substraten 2 mit Bauelementen 3 näher erläutert:
Beim Verfahren zum Abholen von Bauelementen 3 werden zunächst die Pipetten 8 mehrerer Pipettenträger 7 relativ zueinander derart vorpositioniert, dass sich allein durch eine Verfahrbewegung eines der Bestückköpfe 6 in x-Richtung die mehreren Pipetten 8 oberhalb der jeweiligen Abholpositionen 26 der abzuholenden Bauelemente 3 befinden. Durch eine gleichzeitige Zustellbewegung der Pipetten 8 in z-Richtung können die Bauelemente 3 anschließend gleichzeitig von ihren Abholpositionen 26 abgeholt werden. Hierbei bietet der Pipettenträger 7 mit mehreren geradlinig in einer Reihe angeordneten Pipetten den Vorteil, dass bei Übereinstimmung des Teilungsabstands der am Pipettenträger 7 angeordneten Pipetten 8 mit dem Teilungsabstand der Abholpositionen 26 mehrere Pipetten 8 desselben Pipettenträgers 7 gleichzeitig Bauelemente 3 aufnehmen können.

Auch beim Verfahren zum Bestücken von Substraten 2 mit Bauelementen 3 werden zunächst die Pipetten 8 mehrerer Pipettenträger 7 derart vorpositioniert, dass ihre relative Lage zueinander der relativen Lage der entsprechenden Bestückpositionen auf dem Substrat 2 entspricht, wobei hierzu wiederum lediglich die Freiheitsgrade des Bestückkopfs 6 ausgenutzt werden. Die relative Lage des Positioniersystems 9 zum Substrat 2 bleibt hierbei unverändert. Anschließend werden durch eine gleichzeitige Zustellbewegung der vorpositionierten Pipetten 8 in z-Richtung mehrere Bauelemente gleichzeitig auf ihre jeweiligen Bestückpositionen auf dem Substrat 2 abgesetzt. Soll ein weiterer Streifen S des Substrats 2 bestückt werden, so kann hierzu entweder das Positioniersystem 9 in y-Richtung verfahren werden (sofern es entsprechend verfahrbar ausgebildet ist), oder - falls das Positioniersystem 9 als feststehendes Portal ausgebildet ist - das Substrat 2 wird entlang der Transportstrecke 4 um eine Streifenbreite in y-Richtung weitertransportiert.

### Bezugszeichenliste

- 1: Bestückautomat
- 2: Substrat
- 3: Bauelement
- 4: Transportstrecke
- 5: Zuführeinrichtung
- 6: Bestückkopf
- 7: Pipettenträger
- 7-1x: erster Pipettenträger
- 7-2: zweiter Pipettenträger
- 8: Pipette
- 9: Positioniersystem
- 10: Antriebseinheit
- 11: Führungselement
- 12: Achse
- 13: Rotor
- 14: Drehantrieb
- 15: z-Antrieb
- 16: Stator
- 17: Chassis
- 18: Pipettenachse
- 22: Linearführung
- 23: Schwenkarm
- 26: Abholposition
- 27: Querträger
- 28: Portalarm

## Patentansprüche

1. Bestückkopf (6) zum Bestücken von Substraten (2) mit Bauelementen (3) für einen Bestückautomaten (1),
- mit mindestens einem ersten und einem zweiten Pipettenträger (7-1x, 7-2), welche zum Aufnehmen von Pipetten (8) ausgestaltet sind,
- wobei zumindest der erste Pipettenträger (7-1x) mehrere Pipetten (8) zum Handhaben der Bauelemente (3) aufweist,
▪ wobei die Pipetten (8) an ihrem jeweiligen Pipettenträger (7) in einer Ebene parallel zu einer Ebene des Substrats (2) angeordnet sind,
▪ wobei die Pipetten (8) entlang einer jeweiligen Pipettenachse (18) relativ zu ihrem jeweiligen Pipettenträger (7) in einer z-Richtung senkrecht zur Ebene des Substrats (2) verschiebbar und um diese jeweilige Pipettenachse (18) drehbar sind,
wobei zumindest der erste Pipettenträger (7-1x) um eine Drehachse (12), welche senkrecht zur Ebene des Substrats (2) orientiert ist, drehbar ist, wobei
die Drehachse (12) relativ zum jeweiligen Pipettenträger (7) außermittig angeordnet ist, so dass der jeweilige Pipettenträger (7) in einer Ebene parallel zur Ebene des Substrats (2) schwenkbar ist, **dadurch gekennzeichnet, dass** der erste Pipettenträger (7-x) unabhängig von dem zweiten Pipettenträger (7-2) schwenkbar ist.

2. Bestückkopf (6) nach Anspruch 1,
**dadurch gekennzeichnet,**
**dass** der Bestückkopf (6) an einem Positioniersystem (9) des Bestückautomaten (1) linear verfahrbar angeordnet ist, so dass ein relativ zum Bestückautomaten (1) feststehendes Substrat (2) bei gleichzeitig relativ zum Bestückautomaten (1) festgehaltenem Positioniersystem (9) zumindest streifenweise bestückbar ist.

3. Bestückkopf (6) nach einem der Ansprüche 1 bis 2,
**dadurch gekennzeichnet,**
**dass** zumindest einer der Pipettenträger (7) zumindest in einer Richtung parallel zur Ebene des Substrats (2) am Bestückkopf (6) relativ zum anderen Pipettenträger (7) linear verfahrbar ist.

4. Bestückkopf (6) nach einem der Ansprüche 1 bis 3,
**dadurch gekennzeichnet,**
**dass** jeder Pipettenträger (7) einen z-Antrieb (15) zum Bewegen zumindest einer der Pipetten (8) entlang ihrer jeweiligen Achse (18) in z-Richtung aufweist, wobei der z-Antrieb (15) an zumindest eine beliebige Pipette (8) des jeweiligen Pipettenträgers (7) ankoppelbar ist.

5. Bestückkopf (6) nach einem der Ansprüche 1 bis 3,
**dadurch gekennzeichnet,**
**dass** jeder Pipette (8) eines Pipettenträgers (7) ein eigener, separat ansteuerbarer z-Antrieb (15) zugeordnet ist, welcher eine Bewegung der jeweiligen Pipette (8) in z-Richtung ermöglicht.

6. Bestückkopf (6) nach einem der Ansprüche 1 bis 5,
**dadurch gekennzeichnet,**
**dass** jeder Pipette (8) eines Pipettenträgers (7) ein eigener, separat ansteuerbarer Drehantrieb (14) zugeordnet ist, welcher eine Drehbewegung der jeweiligen Pipette (8) um ihre jeweilige Achse (18) ermöglicht.

7. Bestückkopf (6) nach einem der Ansprüche 1 bis 6,
**dadurch gekennzeichnet,**
**dass** zumindest der erste Pipettenträger (7) einen Stator (16) sowie einen um die Drehachse (12) drehbaren Rotor (13) aufweist, an dem die mindestens zwei Pipetten (8) angeordnet sind.

8. Bestückkopf (6) nach einem der Ansprüche 1 bis 7,
**dadurch gekennzeichnet,**
**dass** zumindest der erste Pipettenträger (7) mehrere Pipetten (8) aufweist, welche in einer Reihe geradlinig angeordnet sind, so dass der Pipettenträger (7) mittels der außermittig angeordneten Drehachse (12) in einer Ebene parallel zur Ebene des Substrats (2) schwenkbar ist.

9. Bestückautomat (1) zum Bestücken von Substraten (2) mit Bauelementen (3),
welcher ein Positioniersystem (9), das an einem Chassis (17) des Bestückautomaten (1) angeordnet und zum Aufnehmen mindestens eines Bestückkopfs (6) ausgebildet ist, sowie einen ersten Bestückkopf (6) nach einem der Ansprüche 1 bis 8 aufweist.

10. Bestückautomat (1) nach Anspruch 9,
**dadurch gekennzeichnet,**
**dass** das Positioniersystem (9) als feststehendes Portal ausgebildet ist, welches fest mit dem Chassis (17) verbunden ist, so dass der Bestückkopf (6) mittels des Positioniersystems (9) ausschließlich linear verfahrbar ist.

11. Bestückautomat (1) nach einem der Ansprüche 8 bis 10,
**dadurch gekennzeichnet,**
**dass** mehrere Bauelemente (3) gleichzeitig auf dem Substrat (2) positionierbar sind.

12. Bestückautomat (1) nach einem der Ansprüche 8 bis 11,
**dadurch gekennzeichnet,**
- **dass** mindestens ein weiterer Bestückkopf (6) an dem Positioniersystem (9) verfahrbar angeordnet ist, und
- **dass** jedem der Bestückköpfe (6) eine eigene Antriebseinheit (10) zugeordnet ist, welche eine voneinander unabhängige Bewegung der Bestückköpfe (6) an dem Positioniersystem (9) ermöglichen.

13. Verfahren zum Abholen von Bauelementen (3) mit Hilfe eines Bestückkopfs (6), der nach einem der Ansprüche 1 bis 7 für einen Bestückautomaten (1) ausgebildet ist,
wobei der Bestückautomat (1) Zuführeinrichtungen (5) aufweist, mittels derer die Bauelemente (3) an Abholpositionen bereitgestellt werden,
bei dem die Pipetten (8) mehrerer Pipettenträger (7) derart vorpositioniert werden, dass mehrere Bauelemente (3) gleichzeitig durch eine Zustellbewegung der jeweiligen Pipetten (8) in einer z-Richtung senkrecht zu einer Ebene des Substrats (2) von ihren jeweiligen Abholpositionen abgeholt werden.

14. Verfahren zum Bestücken von Substraten (2) mit Bauelementen (3) mit Hilfe eines Bestückkopfs (6), der nach einem der Ansprüche 1 bis 7 für einen Bestückautomaten (1) ausgebildet ist,
wobei Pipetten (8) mehrerer Pipettenträger (7) des Bestückkopfs (6) derart vorpositioniert werden, dass mehrere von den Pipetten (8) gehaltene Bauelemente (3) gleichzeitig auf dem Substrat (2) positioniert werden.

## Claims

1. A placement head (6) for placing components (3) onto substrates (2) for an placement machine (1),
- with at least one first and one second pipette carrier (7-1x, 7-2), which are configured for picking up pipettes (8),
- wherein at least the first pipette carrier (7-1x) comprises multiple pipettes (8) for the handling of the components (3),
• wherein the pipettes (8) are arranged on their respective pipette carrier (7) in a plane that is parallel to a plane of the substrate (2),
• wherein the pipettes (8) are moveable along a respective pipette axis (18) relative to their respective pipette carrier (7) in a z-direction perpendicular to the plane of the substrate (2) and are rotatable about this respective pipette axis (18),
wherein at least the first pipette carrier (7-1x) is rotatable about an axis of rotation (12) which is orientated perpendicular to the plane of the substrate (2), wherein the axis of rotation (12) is arranged out of centre relative to the respective pipette carrier (7) so that the respective pipette carrier (7) is pivotable in a plane that is parallel to the plane of the substrate (2), **characterized in that** the first pipette carrier (7-1x) is pivotable independently of the second pipette carrier (7-2).

2. The placement head (6) according to claim 1, **characterized in that** the placement head (6) is linearly moveably arranged on a positioning system (9) of the placement machine (1) so that a substrate (2) that is stationary relative to the placement machine (1) can be mounted at least by strips with positioning system (9) simultaneously held fixed relative to the placement machine (1).

3. The placement head (6) according to any one of the claims 1 to 2, **characterized in that** at least one of the pipette carriers (7) at least in a direction parallel to the plane of the substrate (2) is linearly moveable on the placement head (6) relative to the other pipette carrier (7).

4. The placement head (6) according to any one of the claims 1 to 3, **characterized in that** each pipette carrier (7) comprises a z-drive (15) for moving at least one of the pipettes (8) along their respective axis (18) in z-direction, wherein the z-drive (15) can be coupled to at least one random pipette (8) of the respective pipette carrier (7).

5. The placement head (6) according to any one of the claims 1 to 3, **characterized in that** each pipette (8) of a pipette carrier (7) is assigned an own, separately activatable z-drive (15), which makes possible movement of the respective pipette (8) in z-direction.

6. The placement head (6) according to any one of the claims 1 to 5, **characterized in that** each pipette (8) of a pipette carrier (7) is assigned an own, separately activatable rotary drive (14), which makes possible a rotary movement of the respective pipette (8) about its respective axis (18).

7. The placement head (6) according to any one of the claims 1 to 6, **characterized in that** at least the first pipette carrier (7) comprises a stator (16) and a rotor (13) that is rotatable about the axis of rotation (12), on which the at least two pipettes (8) are arranged.

8. The placement head (6) according to any one of the claims 1 to 7, **characterized in that** at least the first pipette carrier (7) comprises multiple pipettes (8), which are linearly arranged in a row so that the pipette carrier (7) by means of the axis of rotation (12) that is arranged out of centre can be pivoted in plane that is parallel to the plane of the substrate (2).

9. The placement machine (1) for placing components (3) onto substrates (2), which comprises a positioning system (9), which is arranged on a chassis (17) of the placement machine (1) and designed for receiving at least one placement head (6), and a first placement head (6) according to any one of the claims 1 to 8.

10. The placement machine (1) according to claim 9, **characterized in that** the positioning system (9) is designed as a fixed gantry which is connected to the chassis (17) in a fixed manner, so that the placement head (6) by means of the positioning system (9) is exclusively moveable linearly.

11. The placement machine (1) according to any one of the claims 8 to 10, **characterized in that** multiple components (3) can be simultaneously positioned on the substrate (2).

12. The placement machine (1) according to any one of the claims 8 to 11, **characterized**
- **in that** at least one further placement head (6) is moveably arranged on the positioning system (9), and
- **in that** each of the placement heads (6) is assigned an own drive unit (10), which make possible movement of the placement heads (6) on the positioning system (9) that is independent of one another.

13. A method for picking components (3) with the help of a placement head (6), which is designed according to any one of the claims 1 to 7, for an placement machine (1), wherein the placement machine (1) comprises feeding devices (5), by means of which the components (3) are placed ready in picking positions, with which the pipettes (8) of multiple pipette carriers (7) are prepositioned in such a manner that multiple components (3) are simultaneously picked up from their respective picking positions through a feeding movement of the respective pipettes (8) in a z-direction perpendicular to a plane of the substrate (2).

14. The method for placing components (3) onto substrates (2) with the help of a placement head (6), which is designed according to any one of the claims 1 to 7 for an placement machine (1), wherein pipettes (8) of multiple pipette carriers (7) of the placement head (6) are prepositioned in such a manner that multiple components (3) held by the pipettes (8) are simultaneously positioned on the substrate (2).

## Revendications

1. Tête d'implantation (6) pour l'implantation de substrats (2) avec des éléments de construction (3) pour un automate d'implantation (1),
- comprenant au moins un premier et un second supports de pipettes (7-1x, 7-2) qui sont conçus pour recevoir des pipettes (8),
- sachant qu'au moins le premier support de pipettes (7-1x) présente plusieurs pipettes (8) pour manipuler les éléments de construction (3),
• sachant que les pipettes (8) sont disposées dans un plan parallèle au plan du substrat (2) sur leur support de pipettes respectif (7),
• sachant que les pipettes (8) peuvent être déplacées le long d'un axe de pipette respectif (18) par rapport à leur support de pipettes respectif (7) dans un sens z vertical au plan du substrat (2) et tourner sur cet axe de pipette respectif (18),
sachant qu'au moins le premier support de pipettes (7-1x) est rotatif sur un pivot (12) qui est orienté verticalement au plan du substrat (2), sachant que
le pivot (12) est excentré par rapport au support de pipettes respectif (7), de sorte que le support de pipettes respectif (7) peut pivoter dans un plan parallèle au plan du substrat (2), **caractérisée en ce que** le premier support de pipettes (7-1x) peut pivoter indépendamment du second support de pipettes (7-2).

2. Tête d'implantation (6) selon la revendication 1, **caractérisée en ce que** la tête d'implantation (6) est agencée en pouvant être déplacée de façon linéaire sur un système de positionnement (9) de l'automate d'implantation (1), de sorte qu'un substrat (2) fixe par rapport à l'automate d'implantation (1) peut être implanté au moins par bandes lorsque le système de positionnement (9) est fixé en même temps par rapport à l'automate d'implantation (1).

3. Tête d'implantation (6) selon la revendication 1 ou 2, **caractérisée en ce qu'**au moins un des supports de pipettes (7) peut être déplacé de façon linéaire par rapport à un autre support de pipettes (7) au moins dans un sens parallèle au plan du substrat (2) sur la tête d'implantation (6).

4. Tête d'implantation (6) selon l'une des revendications 1 à 3, **caractérisée en ce que** chaque support de pipettes (7) présente un entraînement z (15) pour déplacer au moins une des pipettes (8) le long de son axe respectif (18) dans le sens z, sachant que l'entraînement z (15) peut être couplé à au moins une pipette (8) au choix du support de pipette respectif (7).

5. Tête d'implantation (6) selon l'une des revendications 1 à 3, **caractérisée en ce que** chaque pipette (8) d'un support de pipettes (7) a un entraînement z (15) propre, pouvant être entraîné séparément, qui permet un déplacement de la pipette respective (8) dans le sens z.

6. Tête d'implantation (6) selon l'une des revendications 1 à 5, **caractérisée en ce que** chaque pipette (8) d'un support de pipettes (7) a un entraînement rotatif (14) propre, pouvant être entraîné séparément, qui permet une rotation de la pipette respective (8) sur son axe respectif (18).

7. Tête d'implantation (6) selon l'une des revendications 1 à 6, **caractérisée en ce qu'**au moins le premier support de pipettes (7) présente un stator (16) ainsi qu'un rotor rotatif (13) sur le pivot (12), sur lequel les au moins deux pipettes (8) sont agencées.

8. Tête d'implantation (6) selon l'une des revendications 1 à 7, **caractérisée en ce qu'**au moins le premier support de pipettes (7) présente plusieurs pipettes (8) qui sont disposées en ligne droite en rangée, de sorte que le support de pipettes (7) peut pivoter dans un plan parallèle au plan du substrat (2) au moyen du pivot (12) disposé excentré.

9. Automate d'implantation (1) pour l'implantation de substrats (2) avec des éléments de construction (3), qui présente un système de positionnement (9) disposé sur un châssis (17) de l'automate d'implantation (1) et conçu pour recevoir au moins une tête d'implantation (6), ainsi qu'une première tête d'implantation (6) selon l'une des revendications 1 à 8.

10. Automate d'implantation (1) selon la revendication 9, **caractérisé en ce que** le système de positionnement (9) est conçu en tant que portique fixe qui est relié fixement au châssis (17), de sorte que la tête d'implantation (6) peut être déplacée exclusivement de façon linéaire au moyen du système de positionnement (9),

11. Automate d'implantation (1) selon l'une des revendications 8 à 10, **caractérisé en ce que** plusieurs éléments de construction (3) peuvent être positionnés en même temps sur le substrat (2).

12. Automate d'implantation (1) selon l'une des revendications 8 à 11, **caractérisé en ce**
- **qu'**au moins une tête d'implantation (6) supplémentaire est disposée sur le système de positionnement (9) en pouvant être déplacée et
- **que** chaque tête d'implantation (6) a sa propre unité d'entraînement (10) qui permettent un mouvement indépendant l'un de l'autre des têtes d'implantation (6) sur le système de positionnement (9).

13. Procédé pour récupérer des éléments de construction (3) à l'aide d'une tête d'implantation (6) qui est conçue selon l'une des revendications 1 à 7 pour un automate d'implantation (1), sachant que l'automate d'implantation (1) présente des dispositifs d'alimentation (5) au moyen desquels les éléments de construction (3) peuvent être mis à disposition dans des positions de retrait,
dans lequel les pipettes (8) de plusieurs supports de pipettes (7) sont ainsi prépositionnées que plusieurs éléments de construction (3) sont retirés de leur positions de retrait en même temps par un mouvement de distribution des pipettes respectives (8) dans un sens z vertical à un plan du substrat (2).

14. Procédé pour l'implantation de substrats (2) avec des éléments de construction (3) à l'aide d'une tête d'implantation (6) qui est conçue selon l'une des revendications 1 à 7 pour un automate d'implantation (1), sachant que
des pipettes (8) de plusieurs supports de pipettes (7) de la tête d'implantation (6) sont ainsi prépositionnées que plusieurs des éléments de construction (3) tenus par les pipettes (8) sont positionnés en même temps sur le substrat (2).
